# EUROPEAN PATENT APPLICATION

(11) **EP 4 617 775 A1**
(43) Date of publication of application: **17.09.2025**
(21) Application number: 23888530.5
(22) Date of filing: 27.10.2023
(51) Int. Cl.: G03F 7/075, G02B 5/20, G03F 7/004

(54) **PHOTOSENSITIVE RESIN COMPOSITION, PHOTOSENSITIVE RESIN FILM, PHOTOSENSITIVE DRY FILM, PATTERN FORMING METHOD, AND LIGHT-EMITTING ELEMENT**

(30) Priority: 11.11.2022 JP 2022181166
(71) Applicant: SHIN-ETSU CHEMICAL CO., LTD., Tokyo 1000005 (JP)
(72) Inventor: MARUYAMA, Hitoshi, Annaka-shi, Gunma 379-0224 (JP); NOJIMA, Yoshihiro, Annaka-shi, Gunma 379-0195 (JP); AOKI, Shinji, Annaka-shi, Gunma 379-0195 (JP); TOBISHIMA, Kazuya, Annaka-shi, Gunma 379-0195 (JP)
(74) Representative: Schicker, Silvia
(86) International application number: PCT/JP2023/038853
(87) International publication number: WO 2024/101182

(57) **Abstract**

The present invention is a photosensitive resin composition including: (A) a glycidyl group-containing silicone resin; (B) a photocationic polymerization initiator; and (C) a polymer in which a quantum dot having a silane coupling agent coordinated is copolymerized with alkoxysilane, alkoxysilane hydrolysate, or condensate thereof. This can provide: a photosensitive resin composition capable of easily forming a film having high lithography resolution and favorable luminous properties; a photosensitive resin film obtained by using the photosensitive resin composition; patterning processes using these and a photosensitive dry film; and a light emitting device including a cured film obtained by using the photosensitive resin film.

## Description

### TECHNICAL FIELD

The present invention relates to: a photosensitive resin composition; and a photosensitive resin film, a photosensitive dry film, a patterning process, and a light emitting device, which utilize the photosensitive resin composition.

### BACKGROUND ART

Various methods have been proposed to form displays containing red, green, and blue subpixels. As one of such methods, there is a method in which light from an LED array is converted through a color conversion structure such that blue light having a shorter wavelength to red and green light having longer wavelengths. Quantum dots have been employed for this color conversion.

Recently, such LED arrays are fabricated in micro size, and micro-LED displays using these have drawn attention. Although a method of forming a color conversion structure on an LED array includes a lithography process using a photosensitive material (Patent Document 1), further miniaturization has been demanded recently to be used for a small display. In addition, there is a high demand for luminous properties from the viewpoint of display clearness.

### CITATION LIST

### PATENT LITERATURE

Patent Document 1: JP2021-089347A

### NON PATENT LITERATURE

Non Patent Document 1: Journal of Photopolymer Science and Technology, Vol 23, 2010, p115-119

### SUMMARY OF INVENTION

### TECHNICAL PROBLEM

The present invention has been made in view of the above circumstances. An object of the present invention is to provide: a photosensitive resin composition capable of easily forming a film having high lithography resolution and favorable luminous properties; a photosensitive resin film obtained by using the photosensitive resin composition; patterning processes using these and a photosensitive dry film; and a light emitting device including a cured film obtained by using the photosensitive resin film.

### SOLUTION TO PROBLEM

To solve the above problems, the present invention provides a photosensitive resin composition comprising:
(A) a glycidyl group-containing silicone resin;
(B) a photocationic polymerization initiator; and
(C) a polymer in which a quantum dot having a silane coupling agent coordinated is copolymerized with alkoxysilane, alkoxysilane hydrolysate, or condensate thereof.

Such a photosensitive resin composition can easily form a film having high lithography resolution and favorable luminous properties.

Further, in the present invention, the component (C) preferably has a skeleton having a glycidyl group.

Such a photosensitive resin composition can prevent the quantum dot from escaping in developing and can impart high luminous properties to a pattern.

Further, in the present invention, the component (A) preferably has a repeating unit represented by the following formulae (A1) to (A4), 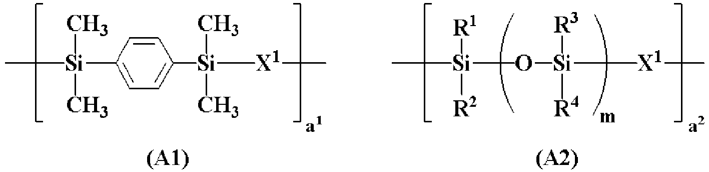 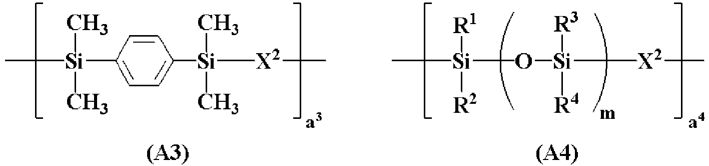 wherein R¹ to R⁴ each independently represent a monovalent hydrocarbon group having 1 to 20 carbon atoms and optionally having a hetero atom; "m" each independently represents an integer of 1 to 600; when "m" is an integer of two or more, R³ each may be same or different from each other and R⁴ each may be same or different from each other; a¹, a², a³, and a⁴ represent numbers satisfying 0<a¹<1, 0<a²<1, 0<a³<1, 0<a⁴<1, and a¹+a²+a³+a⁴=1; X¹ represents a divalent group represented by the following formula (X1); and X² represents a divalent group represented by the following formula (X2), 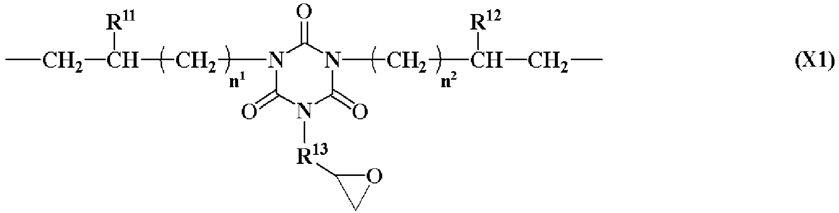 wherein, R¹¹ and R¹² each independently represent a hydrogen atom or a methyl group; n¹ and n² each independently represent an integer of 0 to 7; and R¹³ represents a divalent hydrocarbon group having 1 to 8 carbon atoms and optionally having an ester bond or an ether bond between the carbon atoms. 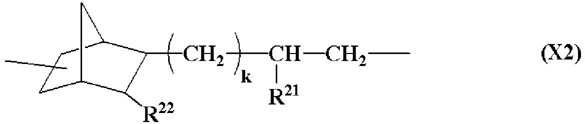 wherein, R²¹ and R²² each independently represent a hydrogen atom or an alkyl group having 1 to 20 carbon atoms and optionally having a hetero atom; and "k" represents an integer of 0 to 10.

When such a photosensitive resin composition is used, the resulting cured film has high reliability.

In the present invention, the component (C) has particularly preferably any one or more kinds of an amino group, a thiol group, a carboxy group, a phosphino group, a phosphine oxide group, or an ammonium ion, as a ligand substituent of the silane coupling agent.

Such a photosensitive resin composition can prevent the quantum dots from escaping during development, and can provide a pattern with high luminous properties.

Further, in the present invention, the component (C) is preferably contained in 5 to 80 mass% of the photosensitive resin composition.

Such a photosensitive resin composition can form a fine pattern while maintaining favorable luminous properties.

The photosensitive resin composition preferably further contains a cation-polymerizable crosslinking agent (D).

Such a photosensitive resin composition can further increase the strength of the resin film after photocuring.

Further, in the present invention, the photosensitive resin composition preferably further comprises a solvent (E).

Such a photosensitive resin composition can improve coatability.

Further, the present invention provides a photosensitive resin film comprising a dried product of the photosensitive resin composition described above.

Such a photosensitive resin film has a high lithography resolution and favorable luminous properties.

Further, the present invention provides a photosensitive dry film comprising: a support film; and the photosensitive resin film described above on the support film.

Such a photosensitive dry film has a high lithography resolution and favorable luminous properties.

Further, the present invention provides a patterning process comprising steps of:
(i) applying the photosensitive resin composition described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

Further, the present invention provides a patterning process comprising steps of:
(i') sticking the photosensitive resin film of the photosensitive dry film described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

By such a patterning process, it is possible to form a pattern with high lithography resolution and obtain a pattern of a film having favorable luminous properties.

Further, the present invention provides a light emitting device comprising a cured film having a pattern formed in the photosensitive resin film described above.

Further, the present invention provides a light emitting device comprising a cured film that has a pattern formed in the photosensitive resin film of the photosensitive dry film described above.

Such a light emitting device has high lithography resolution and favorable luminous properties.

### ADVANTAGEOUS EFFECTS OF INVENTION

The inventive photosensitive resin composition can easily form a film having high resolution and favorable luminous properties thanks to containing a glycidyl group-containing silicone resin, a photocationic polymerization initiator, and a polymer in which a quantum dot having a silane coupling agent coordinated is copolymerized with alkoxysilane, alkoxysilane hydrolysate, or condensate thereof, and therefore is suitable for a light emitting device.

### DESCRIPTION OF EMBODIMENTS

As described above, it has been desired to develop a photosensitive resin composition capable of easily forming a film having high lithography resolution and favorable luminous properties; a photosensitive resin film obtained by using the photosensitive resin composition; patterning processes using these and a photosensitive dry film; and a light emitting device including a cured film obtained by using the photosensitive resin film.

The present inventors have earnestly studied on the above problems; found out that a photosensitive resin composition containing a glycidyl group-containing silicone resin (A), a photocationic polymerization initiator (B), and a polymer (C) in which a quantum dot having a silane coupling agent coordinated was copolymerized with alkoxysilane, alkoxysilane hydrolysate, or condensate thereof, could easily form a film (a photosensitive resin film) having high lithography resolution and favorable luminous properties; and have completed the present invention.

That is, the present invention is a photosensitive resin composition comprising:
(A) a glycidyl group-containing silicone resin;
(B) a photocationic polymerization initiator; and
(C) a polymer in which a quantum dot having a silane coupling agent coordinated is copolymerized with alkoxysilane, alkoxysilane hydrolysate, or condensate thereof.

Hereinafter, the present invention will be described in detail, but the present invention is not limited thereto.

### [Photosensitive Resin Composition]

The inventive photosensitive resin composition contains a glycidyl group-containing silicone resin (A), a photocationic polymerization initiator (B), and a polymer (C) in which a quantum dot having a silane coupling agent coordinated is copolymerized with alkoxysilane, alkoxysilane hydrolysate, or condensate thereof. As necessary, the inventive photosensitive resin composition may further contain other components, such as a cation-polymerizable crosslinking agent (D) and a solvent (E). Hereinbelow, each component constituting the photosensitive resin composition will be described.

### [(A) Glycidyl Group-Containing Silicone Resin]

The glycidyl group-containing silicone resin (A) to be used in the present invention is not particularly limited as long as it has a glycidyl group.

Preferable examples of such a silicone resin include those containing a repeating unit (hereafter, also referred to repeating units A1 to A4, respectively) represented by the following formulae (A1) to (A4).

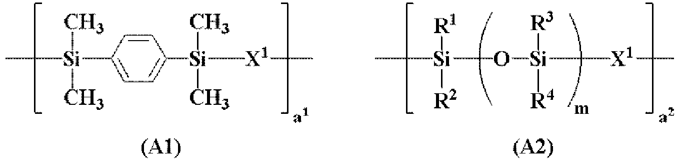

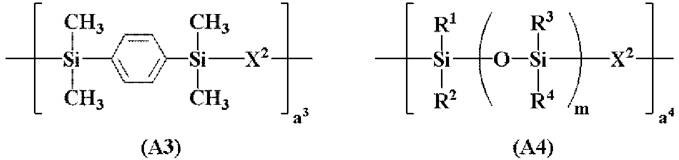

In the formulae (A2) and (A4), R¹ to R⁴ each independently represent a monovalent hydrocarbon group having 1 to 20 carbon atoms and optionally containing a heteroatom. "m" each independently represents an integer of 1 to 600. When "m" is an integer of 2 or more, R³s each may be same or different from each other, and R⁴s each may be same or different from each other. In the repeating units A2 and A4, when the number of siloxane units is 2 or more, the siloxane units each may be same, or two or more kinds of different siloxane units may be incorporated. When two or more kinds of different siloxane units are incorporated (i.e., when "m" is an integer of 2 or more), the siloxane units may be bonded randomly or alternately, or may have multiple blocks each consisting of the same kind of siloxane units included.

The monovalent hydrocarbon group may be linear, branched, or cyclic. Specific examples thereof include monovalent aliphatic hydrocarbon groups, such as alkyl groups having 1 to 20 carbon atoms and alkenyl groups having 2 to 20 carbon atoms; and monovalent aromatic hydrocarbon groups, such as aryl groups having 6 to 20 carbon atoms and aralkyl group having 7 to 20 carbon atoms.

Examples of the alkyl groups include a methyl group, an ethyl group, an n-propyl group, an isopropyl group, a cyclopropyl group, an n-butyl group, an isobutyl group, a sec-butyl group, a tert-butyl group, a cyclobutyl group, an n-pentyl group, a cyclopentyl group, an n-hexyl group, a cyclohexyl group, an n-heptyl group, an n-octyl group, an n-nonyl group, an n-decyl group, a norbornyl group, and an adamantyl group. Examples of the alkenyl groups include a vinyl group, a propenyl group, a butenyl group, and a pentenyl group.

Moreover, the monovalent aliphatic hydrocarbon groups may contain a heteroatom. Specifically, the monovalent aliphatic hydrocarbon groups may have some or all of hydrogen atoms substituted with a halogen atom, such as a fluorine atom, a chlorine atom, a bromine atom, and an iodine atom, or the like. The monovalent aliphatic hydrocarbon groups may have carbon atoms intervened by a carbonyl group, an ether bond, a thioether bond, or the like. Examples of the monovalent aliphatic hydrocarbon groups containing such a heteroatom include a 2-oxocyclohexyl group.

Examples of the aryl groups include a phenyl group, a 2-methylphenyl group, a 3-methylphenyl group, a 4-methylphenyl group, a 2-ethylphenyl group, a 3-ethylphenyl group, a 4-ethylphenyl group, a 4-tert-butylphenyl group, a 4-butylphenyl group, a dimethylphenyl group, a naphthyl group, a biphenylyl group, and a terphenylyl group. Examples of the aralkyl groups include a benzyl group and a phenethyl group.

Further, the monovalent aromatic hydrocarbon groups may contain a heteroatom. Specifically, the monovalent aromatic hydrocarbon groups may have some or all of hydrogen atoms substituted with an alkoxy group having 1 to 10 carbon atoms, an alkylthio group having 1 to 10 carbon atoms, an aryloxy group having 6 to 20 carbon atoms, and an arylthio group having 6 to 20 carbon atoms.

Examples of the alkoxy group having 1 to 10 carbon atoms include a methoxy group, an ethoxy group, an n-propyloxy group, an isopropyloxy group, a cyclopropyloxy group, an n-butyloxy group, an isobutyloxy group, a sec-butyloxy group, a tert-butyloxy group, a cyclobutyloxy group, an n-pentyloxy group, a cyclopentyloxy group, an n-hexyloxy group, a cyclohexyloxy group, an n-heptyloxy group, an n-octyloxy group, an n-nonyloxy group, an n-decyloxy group, a norbornyloxy group, and an adamantyloxy group.

Examples of the alkylthio group having 1 to 10 carbon atoms include a methylthio group, an ethylthio group, an n-propylthio group, an isopropylthio group, a cyclopropylthio group, an n-butylthio group, an isobutylthio group, a sec-butylthio group, a tert-butylthio group, a cyclobutylthio group, an n-pentylthio group, a cyclopentylthio group, an n-hexylthio group, a cyclohexylthio group, an n-heptylthio group, an n-octylthio group, an n-nonylthio group, an n-decylthio group, a norbornylthio group, and an adamantylthio group.

Examples of the aryloxy group having 6 to 20 carbon atoms include a phenyloxy group, a 2-methylphenyloxy group, a 3-methylphenyloxy group, a 4-methylphenyloxy group, a 2-ethylphenyloxy group, a 3-ethylphenyloxy group, a 4-ethylphenyloxy group, a 4-tert-butylphenyloxy group, a 4-butylphenyloxy group, a dimethylphenyloxy group, a naphthyloxy group, a biphenylyloxy group, and a terphenylyloxy group.

Examples of the arylthio group having 6 to 20 carbon atoms include a phenylthio group, a 2-methylphenylthio group, a 3-methylphenylthio group, a 4-methylphenylthio group, a 2-ethylphenylthio group, a 3-ethylphenylthio group, a 4-ethylphenylthio group, a 4-tert-butylphenylthio group, a 4-butylphenylthio group, a dimethylphenylthio group, a naphthylthio group, a biphenylylthio group, and a terphenylylthio group.

Examples of the aryl groups substituted with these groups include a 2-methoxyphenyl group, a 3-methoxyphenyl group, a 4-methoxyphenyl group, a 2-ethoxyphenyl group, a 3-ethoxyphenyl group, a 4-ethoxyphenyl group, a 3-tert-butoxyphenyl group, a 4-tert-butoxyphenyl group, a biphenylyloxyphenyl group, and a biphenylylthiophenyl group.

The number of carbon atoms in the monovalent aliphatic hydrocarbon groups is preferably 1 to 10, more preferably 1 to 8. Moreover, the number of carbon atoms in the monovalent aromatic hydrocarbon groups is preferably 6 to 14, more preferably 6 to 10.

Among these, R¹ to R⁴ are preferably a methyl group, an ethyl group, an n-propyl group, or a phenyl group, more preferably a methyl group or a phenyl group.

In the formulae (A2) and (A4), "m" each independently represents an integer of 1 to 600, preferably an integer of 8 to 800.

In the formulae (A1) to (A4), a¹, a², a³, and a⁴ represent numbers satisfying 0<a¹<1, 0<a²<1, 0<a³<1, 0<a⁴<1, and a¹+a²+a³+a⁴=1, preferably numbers satisfying 0.010≤a¹+a²≤0.490, 0.010≤a³+a⁴≤0.490, 0.050≤a¹+a³≤0.490, 0.010≤a²+a⁴≤0.450, and a¹+a²+a³+a⁴=1, and further preferably numbers satisfying 0.050≤a¹+a²≤0.450, 0.050≤a³+a⁴≤0.450, 0.100≤a¹+a³≤0.475, 0.025≤a²+a⁴≤0.400, and a¹+a²+a³+a⁴=1.

In the formulae (A1) and (A2), X¹ represents a divalent group represented by the following formula (X1).

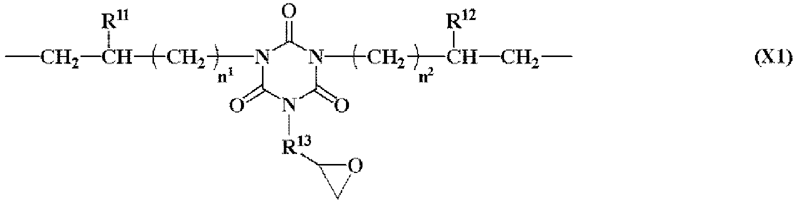

In the formula (X1), R¹¹ and R¹² each independently represent a hydrogen atom or a methyl group and n¹ and n² each independently represent an integer of 0 to 7.

In the formula (X1), R¹³ represents a divalent hydrocarbon group having 1 to 8 carbon atoms and may have an ester bond or an ether bond between the carbon atoms. The divalent hydrocarbon group may be linear, branched, or cyclic. Specific examples thereof include alkanediyl groups, such as a methylene group, an ethane-1,1-diyl group, an ethane-1,2-diyl group, a propane-1,2-diyl group, a propane-1,3-diyl group, a butane-1,2-diyl group, a butane-1,3-diyl group, and a butane-1,4-diyl group. Further, the divalent hydrocarbon group may have carbon atoms intervened by an ester bond or an ether bond. Among these, R¹³ is preferably a methylene group or an ethylene group, more preferably a methylene group.

In the formulae (A3) and (A4), X² represents a divalent group represented by the following formula (X2).

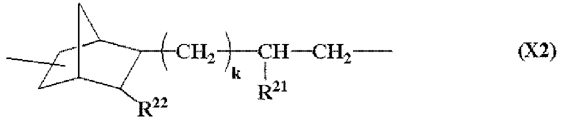

In the formula (X2), R²¹ and R²² each independently represent a hydrogen atom or an alkyl group having 1 to 20 carbon atoms and optionally having a hetero atom. Examples of the alkyl group include the same as those described in the description of R¹ to R⁴. R²¹ and R²² are preferably a hydrogen atom or a methyl group.

In the formula (X2), "k" represents an integer of 0 to 10 and is preferably 0.

The weight-average molecular weight(Mw) of the component (A) of the present invention is preferably 3,000 to 500,000, more preferably 5,000 to 200,000. When the Mw is within the above range, the polymer can be obtained as a solid, and film-formability can be ensured. Incidentally, in the present invention, the Mw is a value measured in terms of polystyrene by gel permeation chromatography (GPC) using tetrahydrofuran (THF) as an elution solvent.

In the component (A) of the present invention, the repeating units A1 to A4 may be bonded randomly or alternately, or may have multiple blocks consisting of each unit included.

In the present invention, the glycidyl group-containing silicone resin (A) is preferably contained in the range 10 to 90 mass%, more preferably in the range of 15 to 85 mass% of the total amount of the photosensitive resin composition.

### [Manufacturing Method of Glycidyl Group-Containing Silicone Resin (A)]

The component (A) of the present invention can be manufactured by addition polymerization of a compound represented by the following formula (1) (hereinafter also referred to as the compound (1)), a compound represented by the following formula (2) (hereinafter also referred to as the compound (2)), a compound represented by the following formula (3) (hereinafter also referred to as the compound (3)), and a compound represented by the following formula (4) (hereinafter also referred to as the compound (4)) in the presence of a metal catalyst.

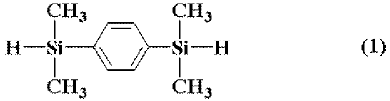

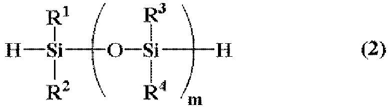

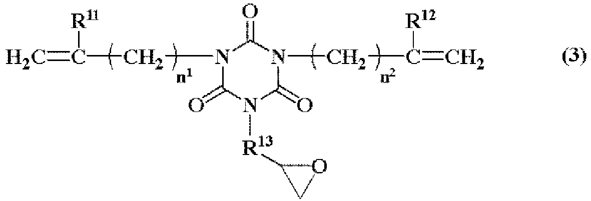

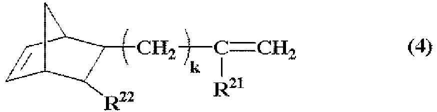

In the formulae, R¹ to R⁴, R¹¹ to R¹³, R²¹, R ²² , "m", "n¹", "n²", and "k" are the same as defined above.

As the metal catalyst, it is possible to use: platinum group metal simple substances, such as platinum (including platinum black), rhodium, and palladium; platinum chloride, chloroplatinic acid and chloroplatinates, such as H₂PtCl₄·xH₂O, H₂PtCl₆·xH₂O, NaHPtCl₆·xH₂O, KHPtCl₆·xH₂O, Na₂PtCl₆·xH₂O, K₂PtCl₄·xH₂O, PtCl₄·xH₂O, PtCl₂, and Na₂HPtCl₄·xH₂O (here, "x" is preferably an integer of 0 to 6, especially 0 or 6 is preferable.); alcohol-modified chloroplatinic acid (for example, those described in US3220972A); complex of chloroplatinic acid and olefin (for example, those described in US3159601A, US3159662A, and US3775452A); platinum group metals, such as platinum black and palladium, supported on carriers, such as alumina, silica, and carbon; rhodium-olefin complex; chlorotris(triphenylphosphine)rhodium (so-called Wilkinson catalyst); and complexes of platinum chloride, chloroplatinic acid, or chloroplatinate with vinyl group-containing siloxanes (especially, vinyl group-containing cyclic siloxanes); etc.

The amount of the catalyst to be used is catalytic amount, generally, preferably is in an amount of 0.001 to 0.1 mass% of the total mass of the compounds (1) to (4) as platinum group metals.

In the polymerization reaction, a solvent may be used as necessary. The solvent is, for example, preferably hydrocarbon solvents, such as toluene and xylene. As polymerization conditions, polymerization is preferably performed at a temperature of 40 to 150°C, particularly 60 to 120°C, from a viewpoint of preventing catalyst deactivation and enabling short time completion of the polymerization. The duration for the polymerization depends on a type and an amount of material compounds, but the polymerization preferably completes in about 0.5 to 100 hours, particularly in 0.5 to 30 hours, in order to avoid intervention of moisture in the polymerization system. When a solvent is used after completion of the polymerization reaction, a glycidyl group-containing silicone resin (A) can be obtained by the distillation of the solvent in such a way.

The reaction method is not particularly limited, but it is preferable to first mix the compound (3) and the compound (4) and heat them; add a metal catalyst to the mixed solution; and then add the compound (1) and the compound (2) dropwise over 0.1 to 5 hours.

The material compounds are preferably blended so that the mole ratio of the hydrosilyl groups in the compounds (1) and (2) to the total of the carbon-carbon double bonds in the compound (3) and the compound (4) is preferably 0.67 to 1.67, and more preferably 0.83 to 1.25. The Mw of the component (A) of the present invention can be controlled by using a monoallyl compound, such as o-allylphenol, or a monohydrosilane or monohydrosiloxane, such as triethylhydrosilane, as a molecular weight regulator.

In the present invention, one kind of the glycidyl group-containing silicone resin (A) may be used, or two or more kinds thereof may be used in combination.

### [(B) Photocationic Polymerization Initiator]

The component (B) photocationic polymerization initiator is not particularly limited, as long as it is decomposed by light radiation to generate a photocationic polymerizable catalyst. The photocationic polymerization initiator preferably generates the catalyst by irradiation with light having a wavelength of 190 to 500 nm. The photocationic polymerization initiator (B) is used as a curing catalyst. Examples of the photocationic polymerization initiator include onium salts, diazomethane derivatives, glyoxime derivatives, β-ketosulfone derivatives, disulfone derivatives, nitrobenzylsulfonate derivatives, sulfonate ester derivatives, imid-yl-sulfonate derivatives, oximesulfonate derivatives, iminosulfonate derivatives, and triazine derivatives.

Examples of the onium salts include a sulfonium salt represented by the following formula (B1) or an iodonium salt represented by the following formula (B2).

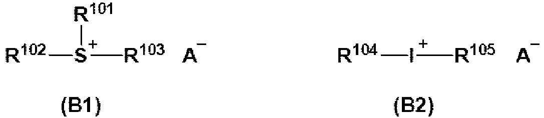

In the formulae (B1) and (B2), R¹⁰¹ to R¹⁰⁵ each independently represent an alkyl group having 1 to 12 carbon atoms and optionally having a substituent, an aryl group having 6 to 12 carbon atoms and optionally having a substituent, or an aralkyl group having 7 to 12 carbon atoms and optionally having a substituent. A⁻ represents a non-nucleophilic counter ion.

The alkyl group may be linear, branched, or cyclic. Specific examples thereof include a methyl group, an ethyl group, an n-propyl group, an isopropyl group, a cyclopropyl group, an n-butyl group, an isobutyl group, a sec-butyl group, a tert-butyl group, a cyclobutyl group, an n-pentyl group, a cyclopentyl group, a cyclohexyl group, a norbornyl group, and an adamantyl group. Examples of the aryl group include a phenyl group, a naphthyl group, and a biphenylyl group. Examples of the aralkyl group include a benzyl group and a phenethyl group.

Examples of the substituents include an oxo group, a linear, branched, or cyclic alkoxy group having 1 to 12 carbon atoms, a linear, branched, or cyclic alkyl group having 1 to 12 carbon atoms, an aryl group having 6 to 24 carbon atoms, an aralkyl group having 7 to 25 carbon atoms, an aryloxy group having 6 to 24 carbon atoms, and an arylthio group having 6 to 24 carbon atoms.

Preferable examples of R¹⁰¹ to R¹⁰⁵ include alkyl groups optionally having a substituent, such as a methyl group, an ethyl group, a propyl group, a butyl group, a cyclohexyl group, a norbornyl group, an adamantyl group, and a 2-oxocyclohexyl group; aryl groups optionally having a substituent, such as a phenyl group, a naphthyl group, a biphenylyl group, an o-, m- or p-methoxyphenyl group, an ethoxyphenyl group, an m- or p-tert-butoxyphenyl group, a 2-, 3- or 4-methylphenyl group, an ethylphenyl group, a 4-tert-butylphenyl group, a 4-butylphenyl group, a dimethylphenyl group, a terphenylyl group, a biphenylyloxyphenyl group, and a biphenylylthiophenyl group; and aralkyl groups optionally having a substituent, such as a benzyl group and a phenethyl group. Among these, aryl groups optionally having a substituent and aralkyl groups optionally having a substituent are more preferable.

Examples of the non-nucleophilic counter ion include halide ions, such as a chloride ion and a bromide ion; fluoroalkanesulfonate ions, such as a triflate ion, a 1,1,1-trifluoroethanesulfonate ion, and a nonafluorobutanesulfonate ion; arylsulfonate ions, such as a tosylate ion, a benzenesulfonate ion, a 4-fluorobenzenesulfonate ion, and a 1,2,3,4,5-pentafluorobenzenesulfonate ion; alkanesulfonate ions, such as a mesylate ion and a butanesulfonate ion; fluoroalkanesulfone imide ions, such as a trifluoromethanesulfone imide ion; fluoroalkanesulfonyl methide ions, such as tris(trifluoromethanesulfonyl)methide ion; and borate ions, such as a tetrakisphenylborate ion and tetrakis(pentafluorophenyl)borate ion.

Examples of the diazomethane derivatives include a compound represented by the following formula (B3).

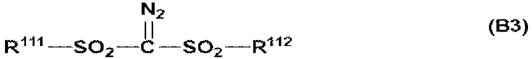

In the formula (B3), R¹¹¹ and R¹¹² each independently represent an alkyl group or halogenated alkyl group having 1 to 12 carbon atoms, an aryl group having 6 to 12 carbon atoms and optionally having a substituent, or an aralkyl group having 7 to 12 carbon atoms.

The alkyl group may be linear, branched, or cyclic. Specific examples thereof include those exemplified in the description of R¹⁰¹ to R¹⁰⁵. Examples of the halogenated alkyl group include a trifluoromethyl group, a 1,1,1-trifluoroethyl group, a 1,1,1-trichloroethyl group, and a nonafluorobutyl group.

Examples of the aryl group optionally having a substituent include a phenyl group; alkoxyphenyl groups, such as a 2-, 3- or 4-methoxyphenyl group, a 2-, 3- or 4-ethoxyphenyl group, and a 3- or 4-tert-butoxyphenyl group; alkylphenyl groups, such as a 2-, 3- or 4-methylphenyl group, an ethylphenyl group, a 4-tert-butylphenyl group, a 4-butylphenyl group, and a dimethylphenyl group; and halogenated aryl groups, such as a fluorophenyl group, a chlorophenyl group, and a 1,2,3,4,5-pentafluorophenyl group. Examples of the aralkyl group include a benzyl group and a phenethyl group.

Examples of the glyoxime derivatives include compounds represented by the following formula (B4).

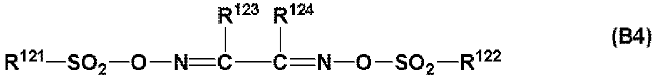

In the formula (B4), R¹²¹ to R¹²⁴ each independently represent an alkyl group or halogenated alkyl group having 1 to 12 carbon atoms, an aryl group having 6 to 12 carbon atoms and optionally having a substituent, or an aralkyl group having 7 to 12 carbon atoms. Alternatively, R¹²³ and R¹²⁴ may bond with each other to form a ring together with carbon atoms bonded with R¹²³ or R¹²⁴. When a ring is formed, a group which R¹²³ and R¹²⁴ are bonded with each other to form is a linear or branched alkylene group having 2 to 12 carbon atoms.

Examples of the alkyl group, the halogenated alkyl group, the aryl group optionally having a substituent, and the aralkyl group include those exemplified as R¹¹¹ and R¹¹². Examples of the linear or branched alkylene groups include an ethylene group, a propylene group, a butylene group, and a hexylene group.

Specific examples of the onium salts include diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, bis(4-tert-butylphenyl)iodonium hexafluorophosphate, diphenyl(4-thiophenoxyphenyl)sulfonium hexafluoroantimonate, [4-(4-biphenylylthio)phenyl]-4-biphenylylphenylsulfonium tris(trifluoromethanesulfonyl)methide, triphenylsulfonium tetrakis(fluorophenyl)borate, tris[4-(4-acetylphenyl)thiophenyl]sulfonium tetrakis(fluorophenyl)borate, triphenylsulfonium tetrakis(pentafluorophenyl)borate, and tris[4-(4-acetylphenyl)thiophenyl]sulfonium tetrakis(pentafluorophenyl)borate.

Specific examples of the diazomethane derivatives include bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-pentylsulfonyl)diazomethane, bis(isopentylsulfonyl)diazomethane, bis(sec-pentylsulfonyl)diazomethane, bis(tert-pentylsulfonyl)diazomethane, 1-cyclohexylsulfonyl-1-(tert-butylsulfonyl)diazomethane, 1-cyclohexylsulfonyl-1-(tert-pentylsulfonyl)diazomethane, and 1-tert-pentylsulfonyl-1-(tert-butylsulfonyl)diazomethane.

Specific examples of the glyoxime derivatives include bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluorooctanesulfonyl)-α-dimethylglyoxime, bis-o-(cyclohexanesulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime, and bis-o-(camphorsulfonyl)-α-dimethylglyoxime.

Specific examples of the β-ketosulfone derivatives include 2-cyclohexylcarbonyl-2-(p-toluenesulfonyl)propane and 2-isopropylcarbonyl-2-(p-toluenesulfonyl)propane.

Specific examples of the disulfone derivatives include diphenyldisulfone and dicyclohexyldisulfone.

Specific examples of the nitrobenzylsulfonate derivatives include 2,6-dinitrobenzyl p-toluenesulfonate and 2,4-dinitrobenzyl p-toluenesulfonate.

Specific examples of the sulfonate ester derivatives include 1,2,3-tris(methanesulfonyloxy)benzene, 1,2,3-tris(trifluoromethanesulfonyloxy)benzene, and 1,2,3-tris(p-toluenesulfonyloxy)benzene.

Specific examples of the imid-yl-sulfonate derivatives include phthalimid-yl-triflate, phthalimid-yl-tosylate, 5-norbornene-2,3-dicarboxyimid-yl-triflate, 5-norbornene-2,3-dicarboxyimid-yl-tosylate, 5-norbornene-2,3-dicarboxyimid-yl-n-butylsulfonate, and n-trifluoromethylsulfonyloxynaphthylimide.

Specific examples of the oximesulfonate derivatives include α-(benzenesulfonium oxyimino)-4-methylphenylacetonitrile.

Specific examples of the iminosulfonate derivatives include (5-(4-methylphenyl)sulfonyloxyimino-5H-thiophen-2-ylidene)-(2-methylphenyl)acetonitrile and (5-(4-(4-methylphenylsulfonyloxy)phenylsulfonyloxyimino)-5H-thiophen-2-ylidene)-(2-methylphenyl)-acetonitrile.

Specific example of the triazine derivatives include 2-[2-(furan-2-yl)ethynyl]-4,6-bis(trichloromethyl)-s-triazine, 2-[2-(5-methylfuran-2-yl)ethynyl]-4,6-bis(trichloromethyl)-s-triazine, 2-(methoxyphenyl)-4,6-bis(trichloromethyl)-s-triazine, 2-[2-(4-methoxyphenyl)ethynyl]-4,6-bis(trichloromethyl)-s-triazine, and 2-[2-(3,4-dimethoxyphenyl)ethynyl]-4,6-bis(trichloromethyl)-s-triazine.

Additionally, 2-methyl-2-[(4-methylphenyl)sulfonyl]-1-[(4-methylthio)phenyl]-1-propane and the like are also suitably usable.

The component (B) photocationic polymerization initiator is particularly preferably the onium salts or the sulfonium salt, and the sulfonium salt is more preferable.

The photocationic polymerization initiator (B) is contained preferably in the range of 0.05 to 20 mass%, more preferably in the range of 0.5 to 10 mass% of the total amount of the photosensitive resin composition. When the photocationic polymerization initiator is contained within the above range, it is excellent in balance between sensitivity during exposure and developability, and capable of obtaining a pattern having excellent resolution without residual film. One kind of the photocationic polymerization initiators may be used, or two or more kinds thereof may be used in combination.

### [(C) Polymer in Which Quantum Dot Having Silane Coupling Agent Coordinated is Copolymerized with Alkoxysilane, Alkoxysilane Hydrolysate, or Condensate Thereof]

A quantum dot is a nano-sized semiconductor substance. Atoms form a molecule, and the molecules constitute a small molecular aggregate called "cluster" to form a nanoparticle. When such a nanoparticle particularly exhibits semiconductor properties, it is called a quantum dot (quantum dot particle).

When a quantum dot is excited by receiving external energy, the quantum dot releases energy (emits light) according to corresponding energy band gap by itself (autonomously) .

The quantum dot used in the present invention is not particularly limited and can be used in any form. A quantum dot is mainly a nanoparticle of 10 nm or less, may be a nanowire, a nanorod, a nanotube, a nanocube, or the like, and can be applied in any shape.

The quantum dot used in the present invention can be selected from any suitable materials, for example as semiconductor materials, selected from the group consisting of II-VI group, III-V group, IV group, IV-VI group, I-III-VI group, II-IV-V group, mixed crystals or alloys thereof, and compounds having a perovskite structure. Specific examples thereof include compounds containing ZnS, ZnSe, ZnTe, CdS, CdSe, CdTe, AlN, AlP, AlAs, AlSb, GaN, GaP, GaAs, GaSb, InN, InP, InAs, InSb, Si, Ge, Sn, Pb, PbS, PbSe, PbTe, SnS, SnSe, SnTe, AgGaS₂, AgInS₂, AgGaSe₂, AgInSe₂, CuGaS₂, CuGaSe₂, CuInS₂, CuInSe₂, ZnSiP₂, ZnGeP₂, CdSiP₂, CdGeP₂, CsPbCl₃, CsPbBr₃, CsPbI₃, CsSnCl₃, CsSnBr₃, or CsSnI₃, but not limited thereto.

The quantum dot used in the present invention may have a core-shell structure. Shell materials capable of forming a core-shell structure are not particularly limited, but preferably has a large band gap and low lattice mismatch with respect to the core material, and can be arbitrarily combined according to the core material. Specific examples of the shell material include ZnO, ZnS, ZnSe, ZnTe, CdS, CdSe, CdTe, AlN, AlP, AlAs, AlSb, GaN, GaP, GaAs, GaSb, InN, InP, InAs, InSb, BeS, BeSe, BeTe, MgS, MgSe, MgTe, PbS, PbSe, PbTe, SnS, SnSe, SnTe, CuF, CuCl, CuBr, and CuI. One kind of these materials may be selected, or two or more kinds thereof may be selected as a mixed crystal made of a plurality of materials, but the materials are not limited thereto.

There are various methods for manufacturing the quantum dot used in the present invention, such as a liquid phase method and a vapor phase method, but in the present invention, the methods are not particularly limited. From the viewpoint of exhibiting high fluorescence emission efficiency, it is preferable to use semiconductor nanoparticles obtained using a hot soap method or a hot injection method, in which a precursor species is reacted at high temperature in a nonpolar solvent having a high boiling point. In order to impart dispersibility in a nonpolar solvent and reduce surface flaws, it is desirable that organic ligands are coordinated on the surface.

The organic ligand preferably has an aliphatic hydrocarbon from the viewpoint of dispersibility. Examples of such an organic ligand include oleic acid, stearic acid, palmitic acid, myristic acid, lauric acid, decanoic acid, octanoic acid, oleylamine, stearyl(octadecyl)amine, dodecyl(lauryl)amine, decylamine, octylamine, octadecanethiol, hexadecanethiol, tetradecanethiol, dodecanethiol, decanethiol, octanethiol, trioctylphosphine, trioctylphosphine oxide, triphenylphosphine, triphenylphosphine oxide, tributylphosphine, and tributylphosphine oxide. One kind of the organic ligands may be used, or two or more kinds thereof may be used in combination.

The surface of the quantum dot is treated with a silane coupling agent. The silane coupling agent preferably has, as a ligand substituent, at least one of an amino group, a thiol group, a carboxyl group, a phosphino group, a phosphine oxide group, and an ammonium ion. Examples of the silane coupling agent include 3-aminopropyltriethoxysilane, 3-aminopropyltrimethoxysilane, aminophenyltrimethoxysilane, N-(2-aminoethyl)-3-aminopropyltriethoxysilane, 3-mercaptopropyltriethoxysilane, 3-mercaptopropyltrimethoxysilane, 3-mercaptopropyl(dimethoxy)methylsilane, triethoxysilylpropylmaleamic acid, [(3-triethoxysilyl)propyl]succinic anhydride, X-12-1135 (manufactured by Shin-Etsu Chemical Co., Ltd.), diethylphosphatoethyltriethoxysilane, 3-trihydroxypropylmethylphosphonate sodium salt, and trimethyl[3-(trimethoxysilyl)propyl]ammonium chloride.

In one embodiment, the quantum dots surface-treated with a silane coupling agent are copolymerized with a condensate of alkoxysilane or a condensate of alkoxysilane hydrolysate. The copolymerization method is not particularly limited. For example, the surface-treated quantum dot and the condensate of alkoxysilane or the condensate of alkoxysilane hydrolysate are mixed in a mixed solvent of toluene and ethanol, and a small amount of water and a catalyst are added to the mixture to react them, so that the quantum dots and the condensate of alkoxysilane or the condensate alkoxysilane hydrolysate can be copolymerized. The kind of the catalyst is not particularly limited, and acids and alkalis may be used. Examples of the catalyst include formic acid, hydrochloric acid, nitric acid, acetic acid, aqueous ammonia, and tetramethylammonium hydroxide.

The structure of the condensate of alkoxysilane or the condensate of alkoxysilane hydrolysate is not particularly limited and may be a cage structure, a ladder structure, a random structure, or the like, and may be appropriately selected according to the purpose. A random structure is preferable from the viewpoint of dispersibility and uniformity in the photosensitive resin. The functional group contained in the condensate of alkoxysilane or the condensate of alkoxysilane hydrolysate is not limited and may be appropriately substituted depending on the purpose. Those having an a glycidyl group capable of performing a crosslinking reaction with the photosensitive resin as a substituent are particularly preferable from the viewpoint of improving the patterning properties of resin composition.

In one embodiment, the quantum dots surface-treated with a silane coupling agent are copolymerized with an alkoxysilane or an alkoxysilane hydrolysate. The copolymerization method is not particularly limited. As a synthesis method, known methods include that are described in Non-Patent Document 1. For example, the surface-treated quantum dots and alkoxysilane are mixed in a mixed solvent of toluene and ethanol, and a small amount of water and a catalyst are added to the mixture to react them, thereby to be able to obtain the quantum dot. There are no particular restrictions on the type or amount of the catalyst, and acids or alkalis may be used. Examples of the catalyst include formic acid, hydrochloric acid, nitric acid, acetic acid, aqueous ammonia, and tetramethylammonium hydroxide.

The silane coupling agent is not particularly limited and can be appropriately selected according to the desired resin properties. The silane coupling agent preferably has a vinyl group, an allyl group, a glycidyl group, a phenyl group, an acryl group, a methacryl group, or a thiol group as a functional group. The alkoxysilane to be used may have not only one kind of functional group but also two or more kinds thereof. Examples of the silane coupling agent include trimethoxyvinylsilane, triethoxyvinylsilane, trimethoxy(4-vinylphenyl)silane, allyltriethoxysilane, allyltrimethoxysilane, triethoxy(3-glycidyloxypropyl)silane, 3-glycidyloxypropyltrimethoxysilane, [8-(glycidyloxy)-n-octyl]trimethoxysilane, KBM-573 (manufactured by Shin-Etsu Chemical Co., Ltd.), (3-methacryloyloxypropyl)triethoxysilane, (3-methacryloyloxypropyl)trimethoxysilane, 3-(trimethoxysilyl)propyl acrylate, 3-mercaptopropyltriethoxysilane, and 3-mercaptopropyltrimethoxysilane.

The alkoxysilane may include not only trialkoxysilane but also dialkoxysilane or monoalkoxysilane. The trialkoxysilane, dialkoxysilane, and monoalkoxysilane may have the same functional group or different functional groups. The functional group is not limited and may be appropriately substituted depending on the purpose. Those having a glycidyl group capable of performing a crosslinking reaction with a photosensitive resin as a substituent are particularly preferable from the viewpoint of improving the patterning properties of the resin composition. By including the dialkoxysilane or the monoalkoxysilane, the degree of crosslinking of the condensate of alkoxysilane or the condensate of alkoxysilane hydrolysate obtained by copolymerization can be controlled; thereby the viscosity of the obtained resin composition can be controlled; and the viscosity can be adjusted according to the manufacturing process. The kind and ratio of these alkoxysilanes are not particularly limited and can be appropriately selected according to the purpose.

Further, in the present invention, the component (C), the polymer in which a quantum dot having a silane coupling agent coordinated is copolymerized with alkoxysilane, alkoxysilane hydrolysate, or condensate thereof, particularly preferably has a glycidyl group that can perform a crosslinking reaction with a photosensitive resin as a substituent from the viewing point of improving patternability of a resin composition.

The amount of the polymer (C) used in the present invention, in which a quantum dot having a silane coupling agent coordinated is copolymerized with alkoxysilane, alkoxysilane hydrolysate, or condensate thereof, is preferably 5 to 80 mass%, more preferably 10 to 70 mass% of the total amount of the photosensitive resin composition. When the content of the quantum dot particles is within the above range, it is possible to form a fine pattern while maintaining favorable luminous properties.

### [(D) Cation-Polymerizable Crosslinking Agent]

The inventive photosensitive resin composition may further contain a cation-polymerizable crosslinking agent as the component (D). The cation-polymerizable crosslinking agent is a component capable of causing a cationic polymerization reaction with an epoxy group of the component (A) and facilitating pattern formation, and also increases further the strength of the resin film after photocuring.

The crosslinking agent is preferably a compound having a molecular weight of 100 to 15,000, more preferably a compound having a molecular weight of 200 to 1,000. When the molecular weight is 100 or more, sufficient photocurability can be obtained. When it is 15,000 or less, it is preferable because there is no risk of deterioration of the heat resistance of the composition after photocuring. The compound may be a resin (polymer), and in that case, the molecular weight is the weight-average molecular weight (Mw).

The cation-polymerizable crosslinking agent is preferably a compound having a functional group selected from an epoxy group, an oxetane group, and a vinyl ether group. One kind of these compounds may be used, or two or more kinds thereof may be used in combination.

When contained, the component (D) is contained preferably in 0.5 to 100 parts by mass, preferably 0.5 to 60 parts by mass, and more preferably 1 to 50 parts by mass based on 100 parts by mass of the component (A). When the component (D) is contained in 0.5 parts by mass or more, sufficient curability can be obtained by irradiation with light. When the component (D) is contained in 100 parts by mass or less, sufficient coatability can be obtained. One kind of the component (D) may be used, or two or more kind thereof may be used in combination.

### [(E) Solvent]

The inventive photosensitive resin composition may further contain a solvent as a component (E). The solvent is not particularly limited as long as it can dissolve each of the components mentioned above. By blending a solvent, the coatability of the photosensitive resin composition can be improved.

An organic solvent is preferable as such a solvent, because the organic solvent is excellent in dissolving these components. Specific examples thereof include ketones, such as cyclohexanone, cyclopentanone, and methyl-2-n-pentyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone. One kind of these solvents may be used, or two or more thereof may be used in a mixture. Particularly preferable solvents are ethyl lactate, cyclohexanone, cyclopentanone, PGMEA, γ-butyrolactone, and a mixed solvent thereof, which are excellent in dissolving the photocationic polymerization initiator.

The component (E) is preferably contained in 25 to 85 mass%, more preferably 35 to 75 mass% of the total amount of the photosensitive resin composition, from the viewpoint of compatibility and viscosity of the photosensitive resin composition.

### [Photosensitive Resin Film]

The inventive photosensitive resin film is a dried product of the photosensitive resin composition described above.

### [Patterning Process Using Photosensitive Resin Composition]

The patterning process using the inventive photosensitive resin composition includes steps of:
(i) applying the photosensitive resin composition described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

The step (i) is a step in which the photosensitive resin composition described above is applied onto a substrate to form a photosensitive resin film on the substrate. Examples of the substrate include a silicon wafer, a glass wafer, a quartz wafer, and a micro LED laminate substrate.

The application method may be a publicly known method, and the examples thereof include a dipping method, a spin-coating method, and a roll-coating method. The amount to be applied can be appropriately selected in accordance with the purpose, but the application is performed so that the obtained photosensitive resin film have preferably a thickness of 0.1 to 200 µm, more preferably 1 to 150 µm.

To enhance the film thickness uniformity of a substrate surface, a solvent may be dropped on the substrate before the photosensitive resin composition is applied (pre-wetting method). The solvent to be dropped can be appropriately selected in accordance with the purpose. Examples of the preferable solvent include alcohols, such as isopropyl alcohol (IPA); ketones, such as cyclohexanone; and glycols, such as propylene glycol monomethyl ether. It is also possible to use the solvent used for the photosensitive resin composition.

In this case, the solvent or the like may be evaporated in advance by pre-heating (pre-baking) as necessary for efficient photocuring reaction. The pre-baking may be performed, for example, at 40 to 140°C for about 1 minute to 1 hour.

Then, (ii) the photosensitive resin film is exposed to light. In this event, the exposure is preferably performed with light having a wavelength of 10 to 600 nm, more preferably performed with light having a wavelength of 190 to 500 nm. The light having such wavelengths are, for example, light having various wavelengths generated from a radiation-beam generating apparatus. Examples of the light include ultraviolet light, such as a g-line, an h-line, and an i-line; and far ultraviolet light (248 nm, 193 nm). Among these, light with a wavelength of 248 to 436 nm is particularly preferable. The exposure dose is preferably 10 to 10,000 mJ/cm².

The exposure may be performed via a photomask. The photomask may have a desired pattern by boring, for example. Incidentally, materials of the photomask are not particularly limited, but are preferably those blocks light having the aforementioned wavelength. For example, a photomask containing chromium is suitably used as a light-blocking film, but is not limited thereto.

Further, in order to enhance the development sensitivity, the post-exposure baking (PEB) may be carried out. The PEB is preferably performed at 40 to 150°C for 0.5 to 20 minutes. PEB makes the exposed part crosslinked to form an insoluble pattern that is insoluble in an organic solvent, which is a developer.

(iii) The exposed photosensitive resin film is developed with a developer after the exposure or PEB, so that an unexposed portion is dissolved and removed to form a pattern. The developer is preferably an organic solvent, and the examples thereof include alcohols, such as IPA; ketones, such as cyclohexanone; and glycols, such as propylene glycol monomethyl ether. It is also possible to use the solvent used for the photosensitive resin composition. Examples of the development method include usual methods, such as a method in which the patterned substrate is soaked into the developer. Then, as necessary, washing, rinsing, drying, and so forth are carried out to obtain a cured film having a desired pattern.

Further, the patterned film may be post-cured using an oven or a hot plate, preferably at 100 to 200°C.

### [Photosensitive Dry Film]

The inventive photosensitive dry film includes: a support film; and a photosensitive resin film on the support film, the photosensitive resin film which is obtained from the photosensitive resin composition.

The photosensitive dry film (the support film and the photosensitive resin film) is solid, and the photosensitive resin film does not contain a solvent. Accordingly, there is no risk that bubbles due to the volatilization of the solvent remain in the photosensitive resin film and between this film and a substrate having asperities. The thickness of the photosensitive resin film is not particularly limited, but is preferably 1 to 200 µm, more preferably 3 to 100 µm.

In addition, the viscosity and fluidity of the photosensitive resin film are closely related. The photosensitive resin film can exhibit appropriate fluidity in an appropriate viscosity range, and the photosensitive resin film enters deeply into a narrow gap and the resin softens, so that the adhesion to a substrate can be enhanced. Thus, the photosensitive resin film preferably has a viscosity of 10 to 5,000 Pa·s, more preferably 30 to 2,000 Pa·s, further preferably 50 to 300 Pa·s at 80 to 120°C, from the viewpoint of the fluidity of the photosensitive resin film. Incidentally, in the present invention, the viscosity is a value measured with a rotational viscometer.

When the inventive photosensitive dry film is brought into close contact with a substrate having asperities, the photosensitive resin film fits in and covers the asperities, so that high flatness can be achieved. Particularly, the inventive photosensitive resin composition is characterized by softening performance so that higher flatness can be achieved. Further, bringing the photosensitive resin film into close contact with the substrate under vacuum environment makes it possible to prevent the occurrence of such a gap therebetween more effectively.

The inventive photosensitive dry film can be manufactured by applying the photosensitive resin composition onto a base material and drying the composition to form a photosensitive resin film. As the manufacturing apparatus for the photosensitive dry film, it is possible to employ a film coater that is commonly used to manufacture adhesive products. Examples of the film coater include a comma coater, a comma reverse coater, a multi coater, a die coater, a lip coater, a lip reverse coater, a die coater, a lip coater, a lip reverse coater, a direct gravure coater, an offset gravure coater, a 3-roll bottom reverse coater, and a 4-roll bottom reverse coater.

When the support film is rolled-out from a roll-out shaft of the film coater and passes through a coater head of the film coater, the photosensitive resin composition is applied onto the support film to have a predetermined thickness; then, the resultant is passed through a hot-air circulating oven at a predetermined temperature for a predetermined period to be dried on the support film and be formed in the photosensitive resin film, so that the photosensitive dry film can be manufactured. It is also possible to manufacture the photosensitive dry film with a protective film as necessary by: passing the photosensitive dry film through a laminate roll under a predetermined pressure together with a protective film that has been rolled-out from another roll-out shaft of the film coater; thereby bonding the protective film to the photosensitive resin film on the support film; and subsequently winding up the resulting laminate to a winding shaft of the film coater. In this case, the temperature is preferably 25 to 150°C, the period is preferably 1 to 100 minutes, and the pressure is preferably of 0.01 to 5 MPa.

The support film used for the inventive photosensitive dry film may be a monolayer film composed of a single film or a multilayer film composed of multiple laminated films. Examples of the material of the film include synthetic resin films, such as polyethylene, polypropylene, polycarbonate, and polyethylene terephthalate. Among these, preferable is polyethylene terephthalate having appropriate flexibility, mechanical strength, and heat resistance. These films may have been subjected to various treatments, such as corona treatment and coating treatment with a releasing agent. Commercial products may be used for these. Examples thereof include: Cerapeel WZ (RX) and Cerapeel BX8 (R) (both are manufactured by Toray Advanced Film Co., Ltd.); E7302 and E7304 (both are manufactured by Toyobo Co., Ltd.); Purex G31 and Purex G71T1 (both are manufactured by Teijin DuPont Films Japan Ltd.); and PET38×1-A3, PET38×1-V8, and PET38×1-X08 (all manufactured by Nippa Co., Ltd.).

The protective film may be the same film as the above-mentioned support film, but polyethylene terephthalate and polyethylene having appropriate flexibility are preferable. Commercial products may be used for these. Examples thereof include the polyethylene terephthalates that have already been exemplified; and polyethylenes, such as GF-8 (manufactured by Tamapoly Co., Ltd.) and PE Film 0-Type (manufactured by Nippa Co., Ltd.).

The thicknesses of both the support film and the protective film are preferably 10 to 100 µm, more preferably 25 to 50 µm, from the viewpoints of stable production of the photosensitive dry film and prevention of film formation in a curled shape around a roll shaft, which is called "curl-prevention".

### [Patterning Process Using Photosensitive Dry Film]

The patterning process, which uses the inventive photosensitive dry film, includes steps of:
(i') sticking the photosensitive resin film of the photosensitive dry film described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

First, (i') the photosensitive dry film is used to form the photosensitive resin film on the substrate by sticking the photosensitive resin film onto a substrate. Specifically, the photosensitive resin film of the photosensitive dry film is sticked to a substrate, so that the photosensitive resin film is formed on the substrate. Meanwhile, in the case where the photosensitive dry film has a protective film, after the protective film is peeled off from the photosensitive dry film, the photosensitive resin film of the photosensitive dry film is sticked to the substrate. The sticking can be performed, for example, by using a film-sticking apparatus.

The film-sticking apparatus is preferably a vacuum laminator. For example, the protective film of the photosensitive dry film is peeled off, and the uncovered photosensitive resin film is brought into close contact with the substrate on a table set at a predetermined temperature by using a sticking roll set at a predetermined pressure in a vacuum chamber set at a predetermined degree of vacuum. The temperature is preferably 60 to 120°C, the pressure is preferably 0 to 5.0 MPa, and the degree of vacuum is preferably 50 to 500 Pa.

For efficient photocuring reaction of the photosensitive resin film and improving adhesiveness between the photosensitive resin film and the substrate, pre-baking may be performed as necessary. The pre-baking may be performed, for example, at 40 to 140°C for about 1 minute to 1 hour.

The photosensitive resin film sticked on the substrate can have a pattern formed as in the case of the patterning process using the photosensitive resin composition by: the step (ii) exposing the photosensitive resin film to light; the step (iii) developing the exposed photosensitive resin film with a developer to dissolve and remove an unexposed portion to form a pattern; and as necessary the step (iv) heating treatment for post-curing. Incidentally, the support film of the photosensitive dry film is peeled off or removed by other methods before the pre-baking or before the PEB, depending on the process.

The patterning processes using the inventive photosensitive resin composition or the inventive photosensitive dry film make it possible to easily form a fine pattern. For example, light in red and green can be emitted thanks to forming a cured film containing red quantum dots and green quantum dots in each segment on a blue micro-LED by: forming a film by using the inventive photosensitive resin composition or the inventive photosensitive dry film so that the film covers numerous blue micro-LEDs paving a substrate; and next performing a fine patterning. Thus, it becomes possible to produce a light emitting device capable of emitting full color.

### [Light Emitting Device]

The inventive light emitting device includes a cured films obtained by the patterning process described above. That is, the inventive light-emitting device is a device including a cured film in which a pattern is formed in the above-described photosensitive resin film or a device including a cured film in which a pattern is formed in the photosensitive resin film of the above-described photosensitive dry film.

### EXAMPLE

Hereinafter, the present invention will be specifically described with reference to Synthesis Examples, Examples, and Comparative Examples. However, the present invention is not limited thereto. Incidentally, a quantum dot of an InP/ZnSe/ZnS core-shell type is used as a quantum dot material. The synthesis methods for the core are as shown below in [1-1] (red quantum dot) and [1-2] (green quantum dot), and the subsequent synthesis method for the shell is as shown in [2].

### [1-1] Synthesis Process of Red Quantum Dot Core

Two flasks were prepared, and 0.23 g (0.9 mmol) of palmitic acid, 0.088 g (0.3 mmol) of indium acetate, and 10 mL of 1-octadecene were added to each flask. The mixtures were heated and stirred at 100°C under reduced pressure, and degassed for 1 hour while dissolving the materials. Then, nitrogen was purged into the two flasks, and 0.75 mL (0.15 mmol) of tristrimethylsilylphosphine/trioctylphosphine solution (0.2 M) was added to both flasks. Then, one of the flasks was heated to 300°C, and it was confirmed that core particles were formed by observing the solution turned from yellow to red. The solution was drawn from the flask that had not been heated and then added gradually to the flask that had been heated to 300°C, thereby to adjust so that the core particle had a desired particle size.

### [1-2] Synthesis Process of Green Quantum Dot Core

0.23 g (0.9 mmol) of palmitic acid, 0.088 g (0.3 mmol) of indium acetate, and 10 mL of 1-octadecene were added to a flask, and the mixture was heated and stirred at 100°C under reduced pressure, and degassed for 1 hour while dissolving the materials. Then, nitrogen was purged into the flask, and 0.75 mL (0.15 mmol) of a solution prepared by mixing tristrimethylsilylphosphine with trioctylphosphine to give a 0.2 M solution was added thereto; the temperature was raised to 300°C; and it was confirmed that core particles were formed by observing the solution turned from yellow to red.

### [2] Synthesis Process of Quantum Dot Shell

Next, 2.85 g (4.5 mmol) of zinc stearate and 15 mL of 1-octadecene were added to another flask, and the mixture was heated and stirred at 100°C under reduced pressure, and degassed for 1 hour while dissolving the zinc stearate, thereby to prepare a 0.3 M zinc stearate octadecene solution. 3.0 mL (0.9 mmol) of the 0.3 M zinc stearate octadecene solution was added to the reacted solution having the core synthesized and the resultant mixture was cooled to 200°C. Next, 0.474 g (6 mmol) of selenium and 4 mL of trioctylphosphine were added to another flask, and the mixture was heated to 150°C for dissolving them, thereby to prepare a 1.5 M selenium trioctylphosphine solution. While increasing the temperature of the reacted solution after the core synthesis process, which had been cooled to 200°C, to 320°C over 30 minutes, the reacted solution was added with the selenium trioctylphosphine solution in 0.1 mL increments to a total of 0.6 mL (0.9 mmol), maintained at 320°C for 10 minutes, and then cooled to room temperature. 0.44 g (2.2 mmol) of zinc acetate was added thereto and dissolved by heating and stirring at 100°C under reduced pressure. The flask was purged again with nitrogen and heated to 230°C, added with 0.98 mL (4 mmol) of 1-dodecanethiol, and held for 1 hour. The obtained solution was cooled to room temperature to prepare a solution containing core-shell type quantum dots. The red core-shell type quantum dot-containing solution synthesized through the processes from [1-1] to [2] is designated R-1, and the green core-shell type quantum dot-containing solution synthesized through the processes from [1-2] to [2] is designated G-1.

### [3] Surface Treatment Process

After the reaction was completed, the reacted solution was cooled to room temperature, and was added with ethanol to make precipitate in the reacted solution, which was then centrifuged to remove the supernatant. The same purification process was repeated again, and the resultant was dispersed in toluene. The toluene solution of the quantum dots was placed in a flask of which content is replaced with nitrogen. 0.24 mL (1.0 mmol) of (3-mercaptopropyl)triethoxysilane was added thereto and stirred at room temperature for 24 hours to perform surface treatment. The quantum dots surface-treated with R-1 were designated R-2, and the quantum dots surface-treated with G-1 were designated G-2.

### [4] Condensation Process of Alkoxysilane or Alkoxysilane Hydrolysate

10 mL of 3-glycidoxypropyltrimethoxysilane, 20 mL of toluene, and 10 mL of methanol were mixed in a flask of which content is replaced with nitrogen, and 4.0 mL of 1.0 N hydrochloric acid was added thereto dropwise little by little while stirring at room temperature. After the dropwise addition, the mixture was stirred at room temperature for 60 minutes, and the solution temperature was increased to 60°C and refluxed to be reacted for 60 minutes. The system was then evacuated for 2 hours at 60°C to distill off the solvent. A condensate of alkoxysilane or a condensate of alkoxysilane hydrolysate, each having a glycidyl group, was obtained in the flask.

### [5] Copolymerization of Quantum Dot with Condensate of Alkoxysilane or Condensate of Alkoxysilane Hydrolysate

The obtained condensate of alkoxysilane or the obtained condensate of alkoxysilane hydrolysate and the surface-treated quantum dot solution obtained in [3] were added to a flask of which content is replaced with nitrogen so that the solid content concentration was 20 mass%, and 20 mL of toluene and 10 mL of methanol were further added and mixed. 4.0 mL of 1.0 N hydrochloric acid was added dropwise thereto little by little while stirring at room temperature. After the dropwise addition, the mixture was stirred at room temperature for 60 minutes; the solution temperature was then increased to 60°C; and the mixture was further allowed to react for 60 minutes under reflux. Thereafter, PGMEA was added thereto, and the toluene solvent was removed by distillation under reduced pressure, thereby to obtain a copolymer of the quantum dots and the condensate of alkoxysilane or the condensate of alkoxysilane hydrolysate. A copolymer of R-2 and the condensate of alkoxysilane or the condensate of alkoxysilane hydrolysate is designated R-3, and a copolymer of G-2 and the condensate of the alkoxysilane or the condensate of alkoxysilane hydrolysate is designated G-3.

### [6] Copolymerization of Quantum Dot with Alkoxysilane or Alkoxysilane Hydrolysate

7 mL of 3-glycidoxypropyltrimethoxysilane, 3 mL of ethoxytrimethylsilane, and the surface-treated quantum dot solution obtained in [3] were added to a flask of which content is replaced with nitrogen so that the solid content concentration was 20 mass%, and 20 mL of toluene and 10 mL of methanol were further added thereto and mixed. 4.0 mL of 1.0 N hydrochloric acid was added dropwise thereto little by little while stirring at room temperature. After the dropwise addition, the mixture was stirred at room temperature for 60 minutes; the solution temperature was then increased to 60°C; and the mixture was further allowed to react for 60 minutes under reflux. Thereafter, PGMEA was added thereto, and the toluene solvent was removed by distillation under reduced pressure, thereby to obtain a copolymer of the quantum dots and the alkoxysilane or the alkoxysilane hydrolysate. A copolymer of R-2 and the alkoxysilane or the alkoxysilane hydrolysate is designated R-4, and a copolymer of G-2 and the alkoxysilane or the alkoxysilane hydrolysate is designated G-4.

### [7] Synthesis of Silicone Resin

### [Synthesis Example 1] Synthesis of Resin 1

Into a 10-L flask equipped with a stirrer, a thermometer, a nitrogen purging device, and a reflux condenser, 238.5 g (0.90 mol) of the compound (S-4) and 16.2 g (0.10 mol) of the compound (S-3b) was added; then, 2,000 g of toluene was added thereto; and the mixture was heated to 70°C. Subsequently, 1.0 g of a toluene solution of chloroplatinic acid (platinum concentration: 0.5 mass%) was introduced, and 184.3 g (0.95 mol) of the compound (S-1) and 79.3 g (0.05 mol) of the compound (S-2b) were added dropwise over 1 hour (total of hydrosilyl groups/total of carbon-carbon double bonds=1/1 (mole ratio)). After completion of the dropwise addition, the mixture was heated to 100°C and aged for 6 hours. Thereafter, toluene was distilled off from the reacted solution under reduced pressure. Thus, the resin 1 was obtained (a siloxane content percentage of 15.3 mass%). The Mw of the resin 1 was 10,000. It was confirmed by ¹H-NMR (manufactured by Bruker) that the resin 1 was a polymer having repeating units A1 to A4.

### [Synthesis Example 2] Synthesis of Resin 2

Into a 10-L flask equipped with a stirrer, a thermometer, a nitrogen purging device, and a reflux condenser, 132.5 g (0.50 mol) of the compound (S-4) and 60.5 g (0.50 mol) of the compound (S-3a) was added; then, 2,000 g of toluene was added thereto; and the mixture was heated to 70°C. Subsequently, 1.0 g of a toluene solution of chloroplatinic acid (platinum concentration: 0.5 mass%) was introduced, and 174.6 g (0.90 mol) of the compound (S-1) and 302.0 g (0.10 mol) of the compound (S-2a) were added dropwise over 1 hour (total of hydrosilyl groups/total of carbon-carbon double bonds=1/1 (mole ratio)). After completion of the dropwise addition, the mixture was heated to 100°C and aged for 6 hours. Thereafter, toluene was distilled off from the reacted solution under reduced pressure. Thus, the resin 2 was obtained (a siloxane content percentage of 45.1 mass%). The Mw of the resin 2 was 42,000. It was confirmed by ¹H-NMR (manufactured by Bruker) that the resin 2 was a polymer having repeating units A1 to A4.

### [Synthesis Example 3] Synthesis of Resin 3

Into a 10-L flask equipped with a stirrer, a thermometer, a nitrogen purging device, and a reflux condenser, 159.0 g (0.60 mol) of the compound (S-4) and 48.4 g (0.40 mol) of the compound (S-3a) was added; then, 2,000 g of toluene was added thereto; and the mixture was heated to 70°C. Subsequently, 1.0 g of a toluene solution of chloroplatinic acid (platinum concentration: 0.5 mass%) was introduced, and 155.2 g (0.80 mol) of the compound (S-1) and 604.0 g (0.20 mol) of the compound (S-2a) were added dropwise over 1 hour (total of hydrosilyl groups/total of carbon-carbon double bonds=1/1 (mole ratio)). After completion of the dropwise addition, the mixture was heated to 100°C and aged for 6 hours. Thereafter, toluene was distilled off from the reacted solution under reduced pressure. Thus, the resin 3 was obtained (a siloxane content percentage of 62.5 mass%). The Mw of the resin 3 was 80,000. It was confirmed by ¹H-NMR (manufactured by Bruker) that the resin 3 was a polymer having repeating units A1 to A4.

The compounds (S-1), (S-2a), (S-2b), (S-3a), (S-3b), and (S-4), which were used in the above Synthesis Examples, are as follows.

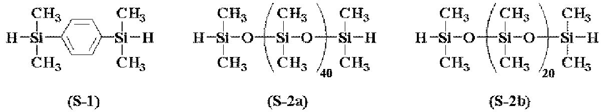

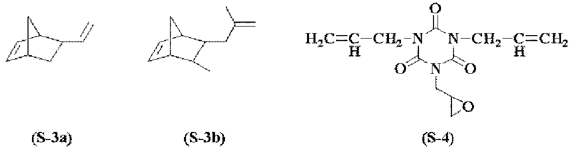

### [8] Preparation and Evaluation of Photosensitive Resin Composition

### [Examples 1 to 12 and Comparative Examples 1 to 24]

Each component was blended according to the blending amounts shown in Tables 1 to 4, then the mixture was mixed and stirred at room temperature, and microfiltered through a 1.0 µm glass filter to obtain the photosensitive resin compositions of Examples 1 to 12 and Comparative Examples 1 to 24.

**[Table 1]**

| Component | | | Example | | | | | |
|---|---|---|---|---|---|---|---|---|
| | | | 1 | 2 | 3 | 4 | 5 | 6 |
| A | Silicone resin | Resin 1 | 100 | | | 100 | | |
| | | Resin 2 | | 100 | | | 100 | |
| | | Resin 3 | | | 100 | | | 100 |
| B | Photocationic polymerizatio1. initiator | B-1 | 2 | | 20 | 2 | | 20 |
| | | B-2 | | 10 | 20 | | 10 | 20 |
| C | Quantum dot | R-3 | 15 | 100 | 350 | | | |
| | | R-4 | | | | 15 | 100 | 350 |
| D | Crosslinking agent | D-1 | | 5 | 30 | | 1 | |
| | | D-2 | | 5 | | | | 20 |
| E | Solvent | Cyclo pentanone | 117 | 220 | 520 | 117 | 211 | 510 |

**[Table 2]**

| Component | | | Example | | | | | |
|---|---|---|---|---|---|---|---|---|
| | | | 7 | 8 | 9 | 10 | 11 | 12 |
| A | Silicone resin | Resin 1 | 100 | | | 100 | | |
| | | Resin 2 | | 100 | | | 100 | |
| | | Resin 3 | | | 100 | | | 100 |
| B | Photocationic polymerization initiator | B-1 | 2 | | 20 | 2 | | 20 |
| | | B-2 | | 10 | 20 | | 10 | 20 |
| C | Quantum dot | G-3 | 15 | 100 | 350 | | | |
| | | G-4 | | | | 15 | 100 | 350 |
| D | Crosslinking agent | D-1 | | 5 | 30 | | 1 | |
| | | D-2 | | 5 | | | | 20 |
| E | Solvent | Cyclo pentanone | 117 | 220 | 520 | 117 | 211 | 510 |

**[Table 3]**

| Component | | | Comparative Example | | | | | | | | | | | |
|---|---|---|---|---|---|---|---|---|---|---|---|---|---|---|
| | | | 1 | 2 | 3 | 4 | 5 | 6 | 7 | 8 | 9 | 10 | 11 | 12 |
| A | Silicone resin | Resin 1 | 100 | | | 100 | | | 100 | | | 100 | | |
| | | Resin 2 | | 100 | | | 100 | | | 100 | | | 100 | |
| | | Resin 3 | | | 100 | | | 100 | | | 100 | | | 100 |
| B | Photocationic polymerization initiator | B-1 | 2 | | 20 | 2 | | 20 | 2 | | 20 | 2 | | 20 |
| | | B-2 | | 10 | 20 | | 10 | 20 | | 10 | 20 | | 10 | 20 |
| C | Quantum dot | R-1 | 15 | 100 | 350 | | | | | | | | | |
| | | R-2 | | | | 15 | 100 | 350 | | | | | | |
| | | R-5 | | | | | | | 15 | 100 | 350 | | | |
| | | R-6 | | | | | | | | | | 15 | 100 | 350 |
| D | Crosslinking agent | D-1 | | 5 | 30 | | 1 | | | 5 | 30 | | 1 | |
| | | D-2 | | 5 | | | | 20 | | 5 | | | | 20 |
| E | Solvent | Cyclo pentanone | 117 | 220 | 520 | 117 | 211 | 510 | 117 | 220 | 520 | 117 | 211 | 510 |

**[Table 4]**

| Component | | | Comparative Example | | | | | | | | | | | |
|---|---|---|---|---|---|---|---|---|---|---|---|---|---|---|
| | | | 13 | 14 | 15 | 16 | 17 | 18 | 19 | 20 | 21 | 22 | 23 | 24 |
| A | Silicone resin | Resin 1 | 100 | | | 100 | | | 100 | | | 100 | | |
| | | Resin 2 | | 100 | | | 100 | | | 100 | | | 100 | |
| | | Resin 3 | | | 100 | | | 100 | | | 100 | | | 100 |
| B | Photocationic polymerization initiator | B-1 | 2 | | 20 | 2 | | 20 | 2 | | 20 | 2 | | 20 |
| | | B-2 | | 10 | 20 | | 10 | 20 | | 10 | 20 | | 10 | 20 |
| C | Quantum dot | G-1 | 15 | 100 | 350 | | | | | | | | | |
| | | G-2 | | | | 15 | 100 | 350 | | | | | | |
| | | G-5 | | | | | | | 15 | 100 | 350 | | | |
| | | G-6 | | | | | | | | | | 15 | 100 | 350 |
| D | Crosslinking agent | D-1 | | 5 | 30 | | 1 | | | 5 | 30 | | 1 | |
| | | D-2 | | 5 | | | | 20 | | 5 | | | | 20 |
| E | Solvent | Cyclo pentanone | 117 | 220 | 520 | 117 | 211 | 510 | 117 | 220 | 520 | 117 | 211 | 510 |

In Tables 1 to 4, the used photocationic polymerization initiators B-1 and B-2 are as follows.

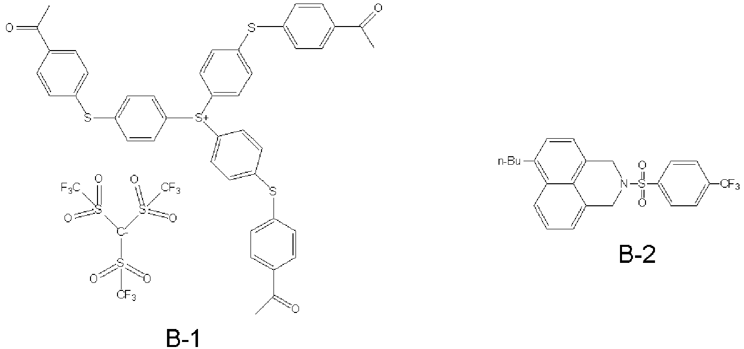

In Tables 1 to 4, the used crosslinking agents D-1 and D-2 are as follows.

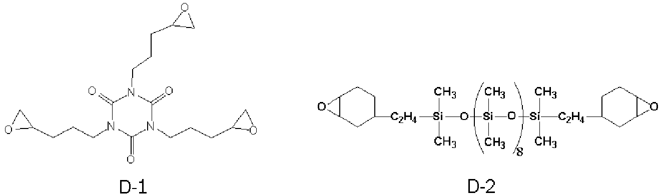

In Tables 1 to 4, for the quantum dots, R-5 is S-BE030 (particle size: 5 to 10 nm, material: InP:ZnS:SeZn = 25:50:25) manufactured by Shoei Chemical Inc.; R-6 is 900514-1ML (particle size: 5 to 10 nm, material: CdSe (core) / CdS (shell) core-shell type) manufactured by Aldrich; G-5 is S-BE029 (particle size: 3 to 5 nm, material: InP:ZnS:SeZn = 25:50:25) manufactured by Shoei Chemical Inc.; and G-6 is 900511-1ML (particle size: 3 to 5 nm, material: CdSe (core) / CdS (shell) core-shell type) manufactured by Aldrich.

### [9] Preparation of Photosensitive Dry Film

Using a die coater as a film coater and a polyethylene terephthalate film (thickness 38 µm) as a support film, the photosensitive resin compositions shown in Tables 1 to 4 each were applied onto the support film. Then, the composition was dried by passing through a hot air circulating oven (length 4 m) set at 100°C for 5 minutes, and a photosensitive resin film was formed on a support film so that the film had a thickness of 30 µm to obtain a photosensitive dry film. A polyethylene film (thickness 50 µm) was laminated as a protective film on the photosensitive resin film at a pressure of 1 MPa using a laminating roll to prepare a photosensitive dry film with a protective film.

### [10] Evaluation of Photosensitive Resin Film

### (1) Checking Presence of Aggregate in Photosensitive Resin Film

A protective film of the photosensitive dry film with a protective film was peeled off, and presence of aggregates in the photosensitive dry film was checked with an optical microscope. A sample having aggregate with a size of 1 µm or more was judged "Bad", and a sample having no aggregate or aggregate with a size of less than 1 µm was judged "Good". The results are shown in Tables 5 to 8.

### (2) Formation and Evaluation of Pattern

In case of the photosensitive dry film with a protective film, a protective film was peeled off, and the photosensitive resin film on a support film was brought into close contact with a silicon wafer using a vacuum laminator TEAM-100RF (manufactured by Takatori Co., Ltd.) with setting the degree of vacuum in a vacuum chamber at 80 Pa. The temperature condition was 100°C. After returning to normal pressure, the substrate was taken out from the vacuum laminator, and the support film was peeled off. Next, in order to enhance the adhesiveness to the substrate, pre-baking was performed on a hot plate at 110°C for 4 minutes. Using an i-line stepper NSR-2205i11D (manufactured by Nikon Corporation), the obtained photosensitive resin film was exposed to light through a mask to form a square island pattern having a pitch distance of 1:1 to an adjacent pattern. After exposure, the substrate was subjected to PEB on a hot plate at 120°C for 5 minutes, and then cooled, and the substrate was spray-developed with PGMEA for 90 seconds to form a pattern. Thereafter, the substrate was post-cured in an oven at 160°C for 3 hours while purging with nitrogen. Then, the formed island patterns having a side of 100 µm, 50 µm, 30 µm, 20 µm, and 15 µm were observed with a scanning electron microscope (SEM), and the size of the smallest pattern that was not connected to the adjacent island pattern (pitch distance 1:1) was defined as limit resolution. When the resolution of a sample did not reach 100 µm or a pattern of a sample was peeled off during development, the sample was judged as "Bad". The results are shown in Tables 5 to 8.

### (3) Evaluation of Luminous Properties of Formed Pattern

Using LabRAM HR Evolution manufactured by Horiba Techno Service Co., Ltd., the patterned sample prepared in (2) above was irradiated with a laser beam (0.03 mW) having a wavelength of 457 nm, the photoconverted island pattern area was measured for emission intensity, emission wavelength, and half band width of the photoconverted light. In addition, the sample prepared in (2) above after the lamination and the support film peeling was similarly measured for the emission intensity of the photoconverted light. The results are shown in Tables 5 to 8 ("M" represents 1 million).

### (4) Evaluation of Reliability

A glass substrate was coated with the photosensitive resin composition shown in Tables 1 to 4 at a film thickness of 80 µm using a spin coater. In order to remove the solvent from the composition, the substrate was placed on a hot plate and dried by heating at 110°C for 10 minutes. The obtained photosensitive resin film was exposed to light through a mask using a contact aligner type exposure apparatus under exposure conditions of 365 nm in order to form a square island pattern having a side of 1 cm. After the irradiation, the substrate was subjected to PEB on a hot plate at 120°C for 5 minutes and then cooled, and spray-developed with PGMEA for 180 seconds to form a pattern. Then, the substrate was post-cured in an oven at 160°C for 3 hours while purging with nitrogen. The patterned sample was treated at 120°C for 500 hours, and then the emission intensity was measured in the same manner as in (3) above to confirm the rate of decrease from the initial value. After the test, the cured coating was checked for condition of separation from the substrate and for the presence or absence of a crack. Those that showed no separation or crack were marked with "Good", and those that showed any separation or a crack were marked with "Bad". The results are shown in Tables 5 to 8.

**[Table 5]**

| | | Example | | | | | |
|---|---|---|---|---|---|---|---|
| | | 1 | 2 | 3 | 4 | 5 | 6 |
| Checking Presence of Aggregate | | Good | Good | Good | Good | Good | Good |
| Limit resolution of patterning / µm | | 15 | 15 | 15 | 15 | 15 | 15 |
| Emission intensity after lamination | | 32M | 108M | 155M | 32M | 110M | 156M |
| Luminous properties of pattern in cured film | Wavelength / nm | 622 | 625 | 626 | 627 | 628 | 628 |
| | Half band width / nm | 42 | 43 | 45 | 42 | 45 | 46 |
| | Emission intensity | 32M | 108M | 155M | 32M | 110M | 156M |
| Change in emission intensity after reliability test / % | | -6 | -4 | -3 | -6 | -3 | -4 |
| Crack, separation after reliability test | | Good | Good | Good | Good | Good | Good |

**[Table 6]**

| | | Example | | | | | |
|---|---|---|---|---|---|---|---|
| | | 7 | 8 | 9 | 10 | 11 | 12 |
| Checking Presence of Aggregate | | Good | Good | Good | Good | Good | Good |
| Limit resolution of patterning / µm | | 15 | 15 | 15 | 15 | 15 | 15 |
| Emission intensity after lamination | | 25M | 87M | 131M | 23M | 86M | 130M |
| Luminous properties of pattern in cured film | Wavelength / nm | 532 | 535 | 538 | 536 | 536 | 538 |
| | Half band width / nm | 37 | 40 | 39 | 38 | 42 | 43 |
| | Emission intensity | 25M | 87M | 131M | 23M | 86M | 130M |
| Change in emission intensity after reliability test / % | | -7 | -3 | -4 | -6 | -4 | -4 |
| Crack, separation after reliability test | | Good | Good | Good | Good | Good | Good |

**[Table 7]**

| | | Comparative Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Checking Presence of Aggregate | | Bad | Bad | Bad | Bad | Bad | Bad | Bad | Bad | Bad | Bad | Bad | Bad |
| Limit resolution of patterning / µm | | 100 | 100 | Bad | 100 | 100 | Bad | 100 | 100 | Bad | 100 | 100 | Bad |
| Emission intensity after lamination | | 15M | 54M | 81M | 14M | 55M | 80M | 16M | 56M | 79M | 16M | 57M | 82M |
| Luminous properties of pattern in cured film | Wavelength / nm | 635 | 637 | 639 | 637 | 638 | 640 | 637 | 636 | 639 | 636 | 637 | 638 |
| | Half band width / nm | 53 | 54 | 56 | 52 | 53 | 56 | 53 | 55 | 56 | 55 | 54 | 57 |
| | Emission intensity | 9M | 30M | 45M | 8M | 32M | 40M | 9M | 33M | 42M | 9M | 33M | 41M |
| Change in emission intensity after reliability test / % | | -44 | -60 | -63 | -44 | -52 | -49 | -73 | -62 | -69 | -55 | -49 | -50 |
| Crack, separation after reliability test | | Bad | Bad | Bad | Bad | Bad | Bad | Bad | Bad | Bad | Bad | Bad | Bad |

**[Table 8]**

| | | Comparative Example | | | | | | | | | | | |
|---|---|---|---|---|---|---|---|---|---|---|---|---|---|
| | | 13 | 14 | 15 | 16 | 17 | 18 | 19 | 20 | 21 | 22 | 23 | 24 |
| Checking Presence of Aggregate | | Bad | Bad | Bad | Bad | Bad | Bad | Bad | Bad | Bad | Bad | Bad | Bad |
| Limit resolution of patterning / µm | | 100 | 100 | Bad | 100 | 100 | Bad | 100 | 100 | Bad | 100 | 100 | Bad |
| Emission intensity after lamination | | 12M | 45M | 67M | 12M | 47M | 66M | 13M | 46M | 67M | 13M | 46M | 66M |
| Luminous properties of pattern in cured film | Wavelength / nm | 541 | 543 | 547 | 542 | 544 | 547 | 544 | 543 | 548 | 542 | 543 | 549 |
| | Half band width / nm | 52 | 55 | 58 | 54 | 57 | 59 | 53 | 54 | 59 | 52 | 55 | 58 |
| | Emission intensity | 7M | 25M | 38M | 7M | 26M | 36M | 8M | 25M | 39M | 8M | 27M | 37M |
| Change in emission intensity after reliability test / % | | -54 | -63 | -65 | -59 | -50 | -45 | -73 | -65 | -57 | -53 | -65 | -56 |
| Crack, separation after reliability test | | Bad | Bad | Bad | Bad | Bad | Bad | Bad | Bad | Bad | Bad | Bad | Bad |

From the above results, the inventive photosensitive resin composition was shown to: be able to form a good photosensitive film and a good photosensitive dry film having no aggregate (or having very small aggregates if it exists); have high lithography resolution, high luminous properties that do not change after the lithography process, and good reliability (low change rate in emission intensity during a heat resistance test, crack resistance, and adhesiveness); and be able to provide a cured film suitable for a light emitting device.

On the other hand, in Comparative Examples 1 to 6 and 13 to 18 in which the used quantum dots as the component (C) were R-1, R-2, G-1, or G-2, which were not copolymerized with alkoxysilane, alkoxysilane hydrolysate, or condensate thereof, aggregate was confirmed to be exist, and thus a good photosensitive resin film could not be formed; their resultant photosensitive resin composition were inferior in lithography resolution, luminous properties before and after the lithography process, change rate in emission intensity in the laser beam resistance test, and adhesiveness to a base material when compared to the inventive photosensitive resin composition; and their cured films were not suitable for a light emitting device.

Similarly, also in Comparative Examples 7 to 12 and 19 to 24 in which commercially available quantum dots R-5, R-6, G-5, and G-6 were used as the component (C), aggregate was confirmed to be exist, and thus a good photosensitive resin film could not be formed; their resultant photosensitive resin composition were inferior in lithography resolution, luminous properties before and after the lithography process, change rate in emission intensity in the laser beam resistance test, and adhesiveness to a base material when compared to the inventive photosensitive resin composition; and their cured films were not suitable for a light emitting device.

The present description includes the following embodiments.
[1]: A photosensitive resin composition comprising:
   (A) a glycidyl group-containing silicone resin;
   (B) a photocationic polymerization initiator; and
   (C) a polymer in which a quantum dot having a silane coupling agent coordinated is copolymerized with alkoxysilane, alkoxysilane hydrolysate, or condensate thereof.
[2]: The photosensitive resin composition according to the above [1], wherein the component (C) has a skeleton having a glycidyl group.
[3]: The photosensitive resin composition according to the above [1] or [2], wherein the component (A) has a repeating unit represented by the following formulae (A1) to (A4), 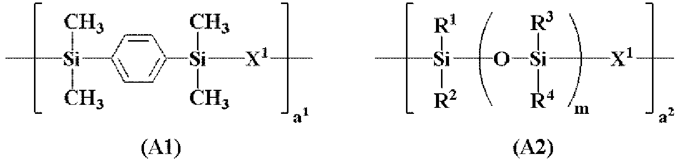 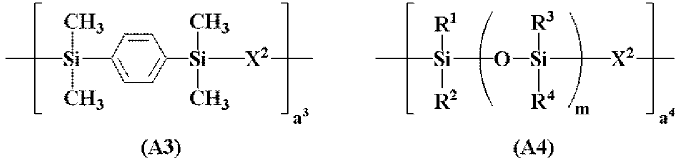 wherein R¹ to R⁴ each independently represent a monovalent hydrocarbon group having 1 to 20 carbon atoms and optionally having a hetero atom; "m" each independently represents an integer of 1 to 600; when "m" is an integer of two or more, R³ each may be same or different from each other and R⁴ each may be same or different from each other; a¹, a², a³, and a⁴ represent numbers satisfying 0<a¹<1, 0<a²<1, 0<a³<1, 0<a⁴<1, and a¹+a²+a³+a⁴=1; X¹ represents a divalent group represented by the following formula (X1); and X² represents a divalent group represented by the following formula (X2), 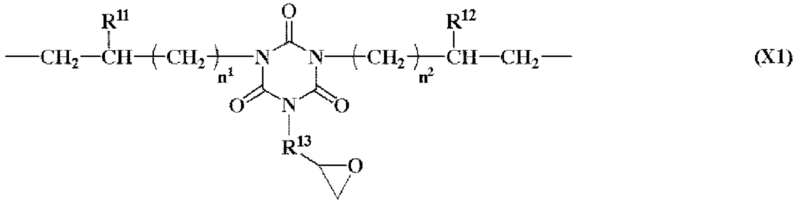 wherein, R¹¹ and R¹² each independently represent a hydrogen atom or a methyl group; n¹ and n² each independently represent an integer of 0 to 7; and R¹³ represents a divalent hydrocarbon group having 1 to 8 carbon atoms and optionally having an ester bond or an ether bond between the carbon atoms, 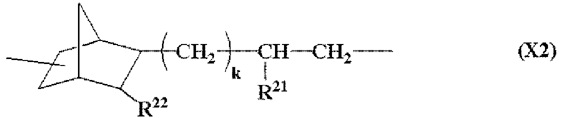 wherein, R²¹ and R²² each independently represent a hydrogen atom or an alkyl group having 1 to 20 carbon atoms and optionally having a hetero atom; and "k" represents an integer of 0 to 10.
[4]: The photosensitive resin composition according to any one of the above [1] to [3], wherein the component (C) has any one or more kinds of an amino group, a thiol group, a carboxy group, a phosphino group, a phosphine oxide group, or an ammonium ion, as a ligand substituent of the silane coupling agent.
[5]: The photosensitive resin composition according to any one of the above [1] to [4], wherein the component (C) is contained in 5 to 80 mass% of the photosensitive resin composition.
[6]: The photosensitive resin composition according to any one of the above [1] to [5], further comprising (D) a cation-polymerizable crosslinking agent.
[7]: The photosensitive resin composition according to any one of the above [1] to [6], further comprising (E) a solvent.
[8]: A photosensitive resin film comprising a dried product of the photosensitive resin composition according to any one of the above [1] to [7].
[9]: A photosensitive dry film comprising:
   a support film; and
   the photosensitive resin film according to the above [8] on the support film.
[10]: A patterning process comprising steps of:
   (i) applying the photosensitive resin composition according to any one of the above [1] to [7] onto a substrate to form a photosensitive resin film on the substrate;
   (ii) exposing the photosensitive resin film to light; and
   (iii) developing the exposed photosensitive resin film with a developer to dissolve and remove an unexposed portion, thereby to form a pattern.
[11]: A patterning process comprising steps of:
   (i') sticking the photosensitive resin film of the photosensitive dry film according to the above [9] onto a substrate to form a photosensitive resin film on the substrate;
   (ii) exposing the photosensitive resin film to light; and
   (iii) developing the exposed photosensitive resin film with a developer to dissolve and remove an unexposed portion, thereby to form a pattern.
[12]: A light emitting device comprising a cured film that has a pattern formed in the photosensitive resin film according to the above [8].
[13]: A light emitting device comprising a cured film that has a pattern formed in the photosensitive resin film of the photosensitive dry film according to the above [9].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A photosensitive resin composition comprising:
(A) a glycidyl group-containing silicone resin;
(B) a photocationic polymerization initiator; and
(C) a polymer in which a quantum dot having a silane coupling agent coordinated is copolymerized with alkoxysilane, alkoxysilane hydrolysate, or condensate thereof.

2. The photosensitive resin composition according to claim 1, wherein the component (C) has a skeleton having a glycidyl group.

3. The photosensitive resin composition according to claim 1, wherein the component (A) has a repeating unit represented by the following formulae (A1) to (A4), 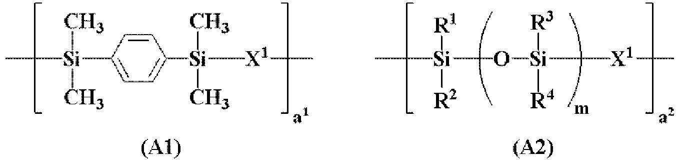 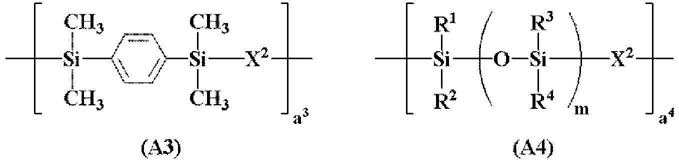 wherein R¹ to R⁴ each independently represent a monovalent hydrocarbon group having 1 to 20 carbon atoms and optionally having a hetero atom; "m" each independently represents an integer of 1 to 600; when "m" is an integer of two or more, R³ each may be same or different from each other and R⁴ each may be same or different from each other; a¹, a², a³, and a⁴ represent numbers satisfying 0<a¹<1, 0<a²<1, 0<a³<1, 0<a⁴<1, and a¹+a²+a³+a⁴=1; X¹ represents a divalent group represented by the following formula (X1); and X² represents a divalent group represented by the following formula (X2), 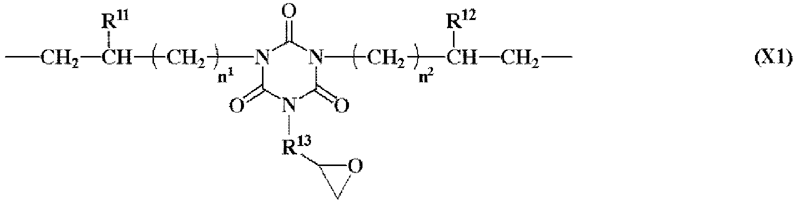 wherein, R¹¹ and R¹² each independently represent a hydrogen atom or a methyl group; n¹ and n² each independently represent an integer of 0 to 7; and R¹³ represents a divalent hydrocarbon group having 1 to 8 carbon atoms and optionally having an ester bond or an ether bond between the carbon atoms, 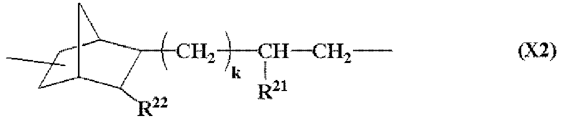 wherein, R²¹ and R²² each independently represent a hydrogen atom or an alkyl group having 1 to 20 carbon atoms and optionally having a hetero atom; and "k" represents an integer of 0 to 10.

4. The photosensitive resin composition according to claim 1, wherein the component (C) has any one or more kinds of an amino group, a thiol group, a carboxy group, a phosphino group, a phosphine oxide group, or an ammonium ion, as a ligand substituent of the silane coupling agent.

5. The photosensitive resin composition according to claim 1, wherein the component (C) is contained in 5 to 80 mass% of the photosensitive resin composition.

6. The photosensitive resin composition according to claim 1, further comprising (D) a cation-polymerizable crosslinking agent.

7. The photosensitive resin composition according to claim 1, further comprising (E) a solvent.

8. A photosensitive resin film comprising a dried product of the photosensitive resin composition according to any one of claims 1 to 7.

9. A photosensitive dry film comprising:
a support film; and
the photosensitive resin film according to claim 8 on the support film.

10. A patterning process comprising steps of:
(i) applying the photosensitive resin composition according to any one of claims 1 to 7 onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

11. A patterning process comprising steps of:
(i') sticking the photosensitive resin film of the photosensitive dry film according to claim 9 onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

12. A light emitting device comprising a cured film that has a pattern formed in the photosensitive resin film according to claim 8.

13. A light emitting device comprising a cured film that has a pattern formed in the photosensitive resin film of the photosensitive dry film according to claim 9.
